# EUROPÄISCHE PATENTSCHRIFT

(11) **EP 2 163 145 B1**
(45) Veröffentlichungstag und Bekanntmachung des Hinweises auf die Patenterteilung: **01.09.2010**
(21) Anmeldenummer: 08760692.7
(22) Anmeldetag: 06.06.2008
(51) Int. Cl.: H05K 1/14, H05K 3/36, H01L 25/065, H01L 23/31

(54) **ELEKTRONIKMODUL UND VERFAHREN ZUR HERSTELLUNG EINES ELEKTRONIKMODULS**
ELECTRONIC MODULE AND METHOD FOR PRODUCING AN ELECTRONIC MODULE
MODULE ÉLECTRONIQUE ET PROCÉDÉ DE FABRICATION D'UN MODULE ÉLECTRONIQUE

(30) Priorität: 30.06.2007 DE 102007032142
(43) Veröffentlichungstag der Anmeldung: 17.03.2010
(73) Patentinhaber: Robert Bosch GmbH, 70442 Stuttgart (DE)
(72) Erfinder: KIMMICH, Peter, 71101 Schoenaich (DE); NGUYEN, Quoc-Dat, 72760 Reutlingen (DE)
(86) Internationale Anmeldenummer: PCT/EP2008/057123
(87) Internationale Veröffentlichungsnummer: WO 2009/003791

(56) Entgegenhaltungen:
- EP-A- 0 486 829
- WO-A-97/50127
- DE-A1- 10 123 249
- US-A- 5 247 423

## Beschreibung

Die Erfindung betrifft ein Elektronikmodul mit einem mindestens ein elektronisches Bauelement aufweisenden ersten Substrat und einem das Substrat einbettenden, als Spritzgussgehäuse oder Spritzpressgehäuse ausgebildeten Gehäuse und mit elektrischen, aus dem Gehäuse herausragenden, mit dem ersten Substrat verbundenen Anschlüssen, die als Stanzgitter ausgebildet sind.

### Stand der Technik

Ein derartiges Elektronikmodul ist bekannt. Das Substrat des Elektronikmoduls weist mindestens ein elektronisches Leistungs- und/oder Logik-Bauelement auf. Das Substrat ist zu seiner äußeren Kontaktierung mit Anschlüssen elektrisch leitend verbunden, die als Stanzgitter ausgebildet sind. Zum Schutz des mit dem elektronischen Bauelement bestückten Substrats wird dieses zusammen mit den Bereichen der Anschlüsse, die mit dem Substrat verbunden sind, in ein Spritzgussgehäuse beziehungsweise Spritzpressgehäuse eingebettet. Die so umspritzten Module sind durch die technischen Bedingungen beim Formgeben, wie zum Beispiel der Geometrie des Spritzgießwerkzeugs, den Füllwegen und dem Fließverhalten des beim Umspritzen verwendeten Kunststoffes und durch die Bauraumgegebenheiten in ihrer Grundfläche beschränkt. Eine Erweiterung des Elektronikmoduls auf mehrere Ebenen erfordert einen komplexen Aufbau mit zusätzlichen Verdrahtungsebenen, wodurch sich die Anzahl der Fertigungsschritte zur Herstellung des Elektronikmoduls stark erhöht.

### Offenbarung der Erfindung

Zur Erhöhung der Bauelementedichte bezogen auf eine Grundfläche des Elektronikmoduls ist vorgesehen, dass im Gehäuse mindestens ein weiteres, mit zweiten elektrischen Anschlüssen versehenes zweites Substrat eingebettet ist, wobei die zweiten Anschlüsse als zweite Stanzgitter ausgebildet sind und die beiden Stanzgitter an mindestens einer Stelle direkt mit einander verbunden sind. Das erste Substrat und das erste Stanzgitter bilden eine erste Baueinheit und das zweite Substrat bildet mit dem zweiten Stanzgitter eine zweite Baueinheit. Die Verdrahtung der auf unterschiedlichen Ebenen angeordneten Substrate erfolgt über die zugeordneten Stanzgitter. Diese haben somit die Aufgabe, eine Außenkontaktierung der Substrate und ihrer elektronischen Bauelemente zu ermöglichen und können alternativ und/oder zusätzlich die Substrate untereinander kontaktieren. Weiterhin geben die Stanzgitter den zugeordneten Substraten zusätzlichen Halt. Dies ist insbesondere vor dem Einbetten der Substrate in das Gehäuse von Vorteil.

Das Gehäuse ist eine die Baueinheiten einbettende Umhüllung selbiger. Zur Ausbildung des Gehäuses als ein die Baueinheiten einbettendes Spritzpressgehäuse werden die Baueinheiten durch Spritzpressen (RTM: Resin Transfer Molding) gemeinsam mit einem Formmaterial umhüllt, das anschließend das Spritzpressgehäuse bildet. Als Formmaterial zur Ausbildung des das Gehäuse wird insbesondere ein duroplastischer Werkstoff oder ein Elastomerwerkstoff verwendet. Zur Ausbildung des Gehäuses als ein die Baueinheiten einbettendes Spritzgussgehäuse werden die Baueinheiten zum Beispiel mittels eines bekannten Spritzgussverfahrens umhüllt.

Weiterhin ist mit Vorteil vorgesehen, dass mindestens eines der Substrate ein keramisches Substrat, insbesondere ein LTCC-Substrat oder ein DBC-Substrat, ist. Derartige Substrate ermöglichen höhere Ströme, isolieren besser und ermöglichen einen Betrieb in einem größeren Temperaturbereich als herkömmliche Substrate. Insbesondere ist das keramische Substrat eine Niedertemperatur-Einbrand-Keramik (LTCC = Low Temperature Confired Ceramics) oder direkt gebondete Kupfersubstrate (DBC = Direct Bonded Copper).

In einer vorteilhaften Ausgestaltung der Erfindung ist vorgesehen, dass die Verbindung der Substrate mit den jeweiligen Stanzgittern eine elektrische und/oder eine mechanische Verbindung ist. Durch die mechanische Verbindung von Stanzgitter und Substrat ergibt sich eine stabile, gute handhabbare Baueinheit. Das Substrat ist insbesondere als Schaltungsträger mit Leiterbahnen ausgebildet. Zur äußeren Kontaktierung der Schaltungsträger über die jeweiligen Anschlüsse sind diese vorzugsweise mit den Leiterbahnen elektrisch verbunden.

Nach einer Weiterbildung der Erfindung ist vorgesehen, dass die Verbindung der Substrate mit den jeweiligen Stanzgittern eine Klebeverbindung und/oder eine Bondverbindung und/oder eine Lötverbindung ist. Die Klebeverbindung ist eine mechanische Verbindung, die elektrisch isolierend, aber auch elektrisch leitend (zum Beispiel von Verwendung von Leitsilber) ist. Durch die Klebeverbindung ergibt sich eine stabile Baueinheit von Substrat und Stanzgitter. Die Bondverbindung ist eine elektrische Verbindung, durch die Substrat und Stanzgitter flexibel miteinander verbunden sind. Die Lötverbindung ist eine elektrische wie mechanische Verbindung von Substrat und Stanzgitter. Die elektronischen Bauelemente werden insbesondere auf die Substrate gelötet oder geklebt. Mit Vorteil wird ein LTCC-Substrat mit geklebten Bauelementen auf das Stanzgitter geklebt und durch Bonden elektrisch verbunden und ein DBC-Substrat zum Löten mit den Bauelementen und dem Stanzgitter bestückt. Insbesondere ist vorgesehen, dass zwei DBC-Substrate oder zwei LTCC-Substrate oder ein LTCC-Substrat und ein DBC-Substrat in einem Elektronikmodul kombiniert werden. In einer vorteilhaften Ausgestaltung der Erfindung ist vorgesehen, dass die Verbindung des ersten Stanzgitters mit dem zweiten Stanzgitter eine die Stanzgitter elektrisch kontaktierende Verbindung ist.

Mit Vorteil ist vorgesehen, dass die elektrisch kontaktierende Verbindung eine Schweiß-, Tox- und/oder Klemmverbindung ist. Die Stanzgitter werden durch einen eine elektrische Kontaktierung ermöglichenden Fügeprozess verbunden.

Die Erfindung betrifft weiterhin ein Verfahren zur Herstellung eines Elektronikmoduls. Dabei ist es vorgesehen, dass das Elektronikmodul ein erstes und mindestens ein zweites Substrat aufweist, die jeweils mindestens ein elektronisches Bauelement aufweisen, wobei das Verfahren folgende Schritte vorsieht:
- Verbinden des ersten Substrats mit einem ersten Stanzgitter zu einer ersten Baueinheit und Verbinden des zweiten Substrats mit einem zweiten Stanzgitter zu einer zweiten Baueinheit,
- Anordnen der Baueinheiten nebeneinander, wobei deren Stanzgitter in mindestens einem Bereich gegeneinander treten,
- Verbinden des ersten und des zweiten Stanzgitters an mindestens einer Stelle des Bereichs und
- gemeinsames Einbetten der Baueinheiten in ein als Spritzgussgehäuse oder Spritzpressgehäuse ausgebildetes Gehäuse.

Durch das Verbinden der Substrate mit den jeweiligen Stanzgittern ergeben sich gut handhabbare Einheiten. Die Baueinheiten werden zum Beispiel durch Aufeinanderlegen neben- beziehungsweise aufeinander angeordnet, sodass ihre Stanzgitter in mindestens einem Bereich gegeneinander treten. Vorzugsweise ist das Stanzgitter ein das Substrat vollständig umgebendes Stanzgitter, dessen Anschlüsse so geformt sind, dass die Substrate beim Gegeneinandertreten mindestens eines Bereichs der Stanzgitter beabstandet gegenüberliegend angeordnet sind. Nach diese Anordnung der Baueinheiten werden diese durch Verbinden des ersten und des zweiten Stanzgitters die beiden Baueinheiten miteinander verbunden und ergeben so eine Gesamteinheit. Die so verbundenen Baueinheiten werden gemeinsam in das Gehäuse eingebettet. Zur Ausbildung des Gehäuses als ein die Baueinheiten einbettendes Spritzpressgehäuse werden die Baueinheiten durch Spritzpressen (RTM: Resin Transfer Molding) gemeinsam mit einem Formmaterial umhüllt, das anschließend das Spritzpressgehäuse bildet. Als Formmaterial zur Ausbildung des das Gehäuse wird insbesondere ein duroplastischer Werkstoff oder ein Elastomerwerkstoff verwendet. Beim Molden werden die Baueinheiten mit einem nicht-leitenden Material direkt umspritzt. Anschließend härtet das Material aus und das Elektronikmodul kann als kompaktes, geschlossenes und robustes Modul verwendet werden. Zur Ausbildung des Gehäuses als ein die Baueinheiten einbettendes Spritzgussgehäuse werden die Baueinheiten zum Beispiel mittels eines bekannten Spritzgussverfahrens umhüllt. Mindestens eines der Substrate ist mit Vorteil ein keramisches Substrat, insbesondere ein LTCC-Substrat oder ein DBC-Substrat. Die elektronischen Bauelemente (Leistungs- oder Logikbauelemente) werden zu Bestückung der Substrate auf diese gelötet und/oder geklebt.

Mit Vorteil ist vorgesehen, dass die Substrate mit den zugeordneten Stanzgittern durch Kleben und/oder Bonden und/oder Löten verbunden werden. Das Substrat wird entweder auf das Stanzgitter geklebt und die elektrischen Verbindungen zum Stanzgitter gebondet oder das Stanzgitter mit den Bauelementen auf das Substrat gelötet. Vorteilhafterweise wird das LTCC-Substrat mit geklebten Bauelementen auf das Stanzgitter geklebt und durch Bonden verbunden. Ein DBC-Substrat wird mit Vorteil zum Löten mit den Bauelementen und dem Stanzgitter bestückt.

Nach einer Weiterbildung der Erfindung ist vorgesehen, dass die Stanzgitter bei ihrem Verbinden elektrisch kontaktiert werden. Durch die elektrische Kontaktierung sind die Substrate untereinander verdrahtet.

In einer vorteilhaften Ausgestaltung der Erfindung ist vorgesehen, dass die nebeneinander angeordneten Baueinheiten in einer von Werkzeugsegmenten eines Spritzgießwerkzeugs beziehungsweise Spritzpresswerkzeugs gebildeten Kavität aufgenommen und durch Spritzgießen beziehungsweise Spritzpressen eingebettet werden. Das Spritzgießwerkzeug beziehungsweise Spritzpresswerkzeug besteht insbesondere aus zwei als Werkzeughälften ausgebildeten Werkzeugssegmenten.
Insbesondere ist vorgesehen, dass mindestens eines der Stanzgitter zusätzlich zu den Anschlüssen mindestens eine die Kavität mitbildende Zusatzstruktur aufweist, die nach dem Einbetten der Baueinheiten im Spritzgussgehäuse - zumindest teilweise - entfernt wird. Die Zusatzstruktur positioniert vor ihrem Entfernen die Anschlüsse innerhalb des Stanzgitters und ist insbesondere als eine zusammenhängende, umlaufende Struktur ausgebildet, die als sogenannter "Dambar" die Kavität mitbildet. Beim Anordnen der Baueinheiten nebeneinander kommen die als Dambar ausgebildeten Zusatzstrukturen der Stanzgitter aufeinander zum liegen. Die Werkzeughälften des Spritzgießwerkzeugs beziehungsweise Spritzpresswerkzeugs drücken auf diese Dambar, wobei die Kavität für das Spritzgussgehäuse hermetisch und sicher abgedichtet wird. Diese Dichtgeometrie ist sehr einfach herstellbar, da sie jeweils in einer Ebene liegt.

Schließlich ist mit Vorteil vorgesehen, dass die Zusatzstruktur zu ihrem Entfernen vom Rest des Stanzgitters durch Stanzen und/oder Laserschneiden und/oder Schweren abgetrennt wird. Nach dem Spritzgießen (Molden) wird insbesondere eine als Dambar ausgebildete Zusatzstruktur zwischen den Anschlüssen durch einen Trennvorgang (zum Beispiel Stanzen, Laserschneiden, Scheren) getrennt, sodass die Anschlüsse elektrisch voneinander getrennt sind. Alternativ können jedoch auch gezielt einige Verbindungen zwischen den beiden Substraten zur Bildung der elektrischen Verbindung verbunden bleiben, sodass ein gemeinsamer Schaltkreis entsteht.

### Kurze Beschreibung der Zeichnungen

Im Folgenden soll die Erfindung anhand folgender Zeichnungen näher erläutert werden. Es zeigen
- Figur 1: eine Draufsicht auf eine Baueinheit mit einem bestückten Substrat und einem Stanzgitter,
- Figur 2: eine Anordnung aus zwei Baueinheiten vor deren Verbinden,
- Figur 3: zwei nebeneinander angeordnete Baueinheiten, deren Stanzgitter gegeneinander treten,
- Figur 4: die verbundenen Baueinheiten der Figuren 2 und 3 in einem Spritzpresswerkzeug und
- Figur 5: ein Elektronikmodul mit im Spritzpressgehäuse eingebetteten Baueinheiten.

### Ausführungsform(en) der Erfindung

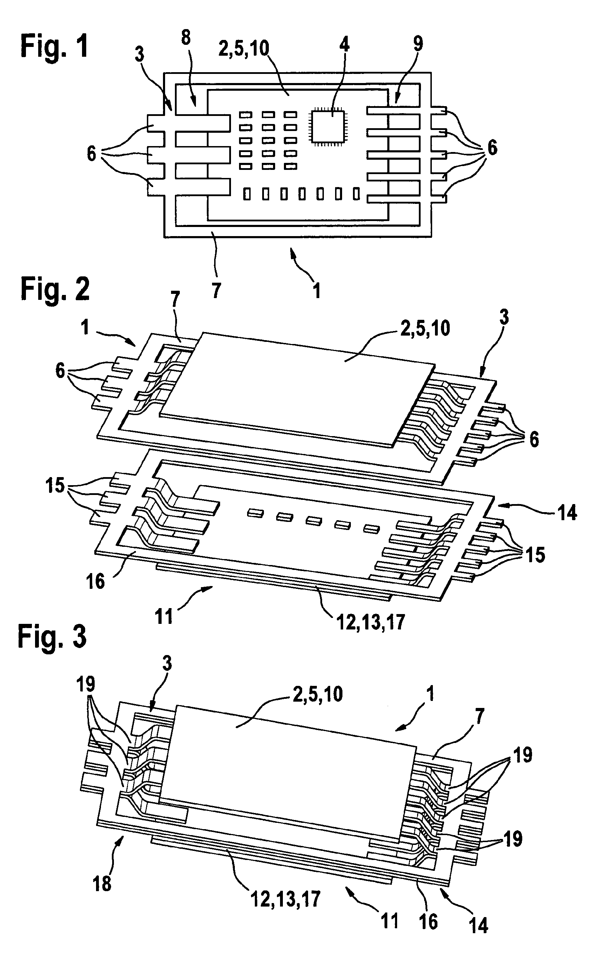

Die Figur 1 zeigt eine erste Baueinheit 1 in Draufsicht mit einem bestückten ersten Substrat 2 und einem Stanzgitter 3. Das Substrat 2 weist elektronische Bauelemente 4 auf, von denen zur Vereinfachung der Darstellung nur eines dargestellt ist. Das erste Substrat 2 ist als Schaltungsträger 5 mit nicht gezeigten Leiterbahnen ausgebildet. Die Leiterbahnen dienen zur Verschaltung der elektronischen Bauelemente 4 innerhalb des Schaltungsträgers 5 und zur Bereitstellung von Kontaktflächen zur Kontaktierung von ersten Anschlüssen 6 des Stanzgitters 3. Das explizit dargestellte Bauelement 4 ist auf das erste Substrat 2 geklebt und zur elektrischen Kontaktierung mit den nicht gezeigten Leiterbahnen durch Bonden verbunden. Alternativ ist das elektronische Bauelement 4 auf das erste Substrat 2 geklebt. Das erste Stanzgitter 3 weist die ersten Anschlüsse 6 und ein die ersten Anschlüsse 6 verbindende und das Substrat 2 der fertigen Baueinheit 1 vollständig umgreifende erste Zusatzstruktur 7 auf. Die ersten Anschlüsse 6 sind innerhalb der ersten Baueinheit 1 so angeordnet, dass drei der ersten Anschlüsse 6 auf einer Seite 8 und vier der Anschlüsse 6 auf einer der einen Seite 8 gegenüberliegenden anderen Seite 9 des ersten Substrats angeordnet sind. Das erste Substrat 2 ist auf das erste Stanzgitter 3 geklebt und die Kontaktflächen des als Schaltungsträger 5 ausgebildeten ersten Substrats 2 sind mit den jeweiligen ersten Anschlüssen 6 des ersten Stanzgitters 3 durch nicht gezeigte Bondverbindungen elektrisch verbunden. Alternativ zur Verbindung durch Kleben und Bonden ist das Stanzgitter 3 mit den Bauelementen 4 auf das Substrat 2 gelötet. Das erste Substrat 2 ist als keramisches Substrat 10 ausgebildet.

Die Figur 2 zeigt die erste Baueinheit 1 und eine zweite Baueinheit 11 in Gegenüberstellung angeordnet. Die zweite Baueinheit ist entsprechend der ersten Baueinheit 1 aufgebaut und weist ebenfalls ein als Schaltungsträger 12 ausgebildetes und mit mindestens einem elektronischen Bauelement 4 bestücktes zweites Substrat 13, sowie ein zweites Stanzgitter 14 auf. Das zweite Stanzgitter 14 besitzt zweite Anschlüsse 15 und eine die zweite Baueinheit 11 umlaufende Zusatzstruktur16. Auch das zweite Substrat ist als keramisches Substrat 17ausgebildet. Beide Baueinheiten 1, 11 weisen somit jeweils ein als keramisches Substrat 10, 17 ausgebildetes Substrat 2, 13 und ein das jeweilige Substrat 2, 13 umgebende Stanzgitter 3, 14 auf. Das keramische Substrat 10 der ersten Baueinheit 1 ist als LTCC-Substrat mit geklebten Bauelementen 4 ausgebildet und auf das Stanzgitter 5 der ersten Baueinheit 1 geklebt. Zur Herstellung der elektrischen Verbindung sind die ersten Anschlüsse 6 des ersten Stanzgitters 3 mit Kontakten auf dem ersten Substrat 2 durch Bondverbindungen elektrisch verbunden. Das keramische Substrat 17 der zweiten Baueinheit 11 ist ein DBC-Substrat, das mit elektrischen Bauelementen 4 und dem entsprechenden zweiten Stanzgitter 14 bestückt und anschließend verlötet ist. Somit besteht bei der zweiten Baueinheit 11 eine Lötverbindung zwischen dem zweiten Stanzgitter 14 und dem zweiten Substrat 13. Bei beiden Baueinheiten 1, 11 sind die Anschlüsse 6, 15 jeweils gekröpft ausgebildet, sodass sich jeweils eine von einer Substratebene des jeweiligen Substrats 2, 13 beabstandete Zusatzstrukturebene der jeweiligen Zusatzstruktur 7, 16 ergibt. Die Baueinheiten 1, 11 sind in der Gegenüberstellung so angeordnet, dass sie mit ihrer jeweiligen Zusatzstrukturebenen und ihren Bauelementen 4 einander zugewandt angeordnet sind.

Die Figur 3 zeigt eine Anordnung der Baueinheiten 1, 11, bei der die jeweils einander entsprechenden, als zusammenhängende und ihre jeweiligen Substrate 2, 13 umlaufende Zusatzstrukturen 7, 16 zur Deckung kommen. Dabei sind die Baueinheiten 1, 11 so nebeneinander angeordnet, dass deren Stanzgitter 3, 14 im Bereich 18 ihrer jeweiligen Zusatzstruktur 7, 16 umfänglich gegeneinander treten. Die so angeordneten Baueinheiten 1, 11 werden anschließend an ihren Stanzgittern 3, 14 im Bereich der umlaufenden Zusatzstrukturen 7, 16 an mindestens einer Stelle 19 miteinander verbunden. Bei dieser Verbindung werden die Stanzgitter 3, 14 miteinander elektrisch kontaktiert.

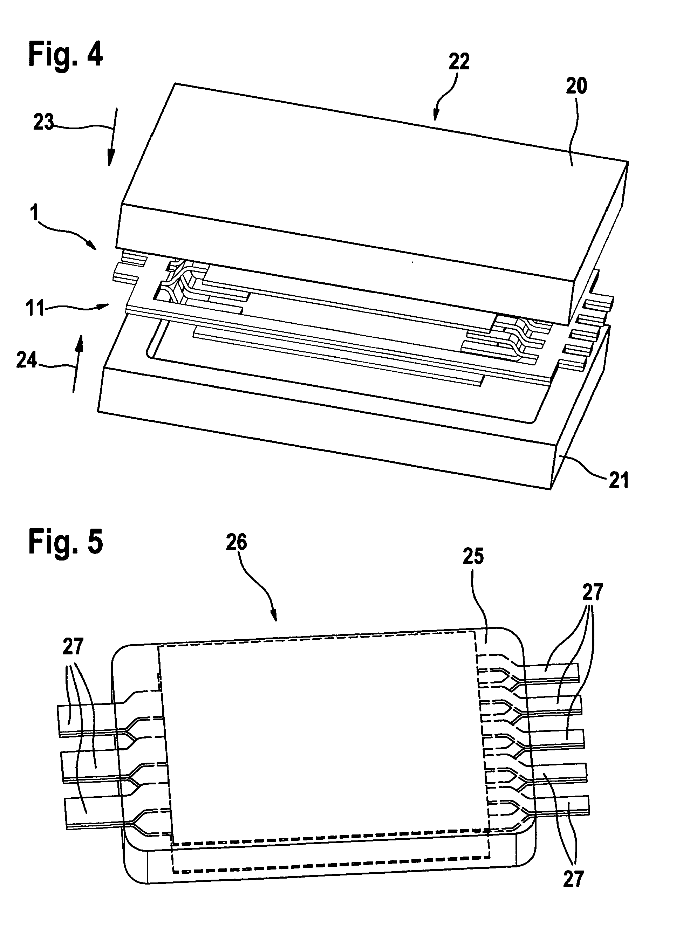

Die Figur 4 zeigt die beiden miteinander verbundenen Baueinheiten 1, 11 in zwei als Werkzeughälften ausgebildeten Werkzeugsegmenten 20, 21 eines Spritzpresswerkzeugs 22. Die beiden Werkzeugsegmente 20, 21 werden beidseitig gegen die aufeinandergelegten, umlaufenden Zusatzstrukturen 7,16 gepresst (Werkzeugsegment 20 in Richtung des Pfeils 23, Werkzeugsegment 21 in Richtung des Pfeils 24). Die Werkzeugsegmente 20, 21 bilden zusammen mit den umlaufenden Zusatzstrukturen 7, 16 eine die Baueinheiten 1, 11 umgebende Kavität, wobei lediglich die außerhalb der Zusatzstrukturen 7, 16 angeordneten Teile der Anschlüsse 6, 15 aus dieser Kavität heraus ragen.

Anschließend werden die innerhalb der Kavität befindlichen Teile der Baueinheiten 1, 11 mit nicht-leitendem Material umspritzt, sodass nach dem Aushärten ein so entstandenes Spritzpressgehäuse 25 des in Figur 5 gezeigten fertigen Elektronikmoduls 26 zusammenhält und stützt. Nach dem Spritzpressprozess (dem Transfer-Molden) werden Teile der Zusatzstrukturen 7, 16 zwischen den von den Anschlüssen 6, 15 gebildeten Anschlusselementen 27 entfernt. Dazu werden diese Teile vom Rest des jeweiligen Stanzgitters 3, 14 durch einen Trennvorgang, zum Beispiel ein Stanzen, Laserschneiden oder Scheren, getrennt. Es können jedoch auch gezielt Teile der Zusatzstrukturen 7, 16 zur Bildung einer elektrischen Verbindung verbunden bleiben.

Die Figuren 1 bist 5 zeigen den Ablauf der einzelnen Verfahrensschritte zur Herstellung eines in Figur 5 gezeigten Elektronikmoduls 26.

Die Anschlüsse 27 des Elektronikmoduls 26 können zur weiteren Verbindung mit der Außenwelt mit speziellen Geometrien versehen werden:
- Einpresstechnik für Schaltungsträger oder Einpresstechnik in Stanzgitter 3, 14,
- Schneidklemmen zur Verbindung mit bedrahteten Bauelementen 4, oder Stanzgittern 3, 14,
- Ausbildung als Steckfahnen für herkömmliche Steckverbindungen oder einer Möglichkeit zum Anschrauben anderer elektrischer Bauteile oder Drähte.

## Patentansprüche

1. Elektronikmodul mit einem mindestens ein elektronisches Bauelement aufweisenden ersten Substrat und einem das Substrat einbettenden, als Spritzgussgehäuse oder Spritzpressgehäuse ausgebildeten Gehäuse und mit elektrischen, aus dem Gehäuse herausragenden, mit dem ersten Substrat verbundenen Anschlüssen, die als Stanzgitter ausgebildet sind, **dadurch gekennzeichnet, dass** im Gehäuse (25) mindestens ein weiteres, mit zweiten elektrischen Anschlüssen (15) versehenes zweites Substrat (13) eingebettet ist, wobei die zweiten Anschlüsse (15) als zweites Stanzgitter (14) ausgebildet sind und die beiden Stanzgitter (3,14) an mindestens einer Stelle (19) direkt miteinander verbunden sind.

2. Elektronikmodul nach Anspruch 1, **dadurch gekennzeichnet, dass** mindestens eines der Substrate (2,13) ein keramisches Substrat (10,17), insbesondere ein LTCC-Substrat (10) oder ein DBC-Substrat (17), ist.

3. Elektronikmodul nach einem der vorhergehenden Ansprüche, **dadurch gekennzeichnet, dass** die Verbindung der Substrate (2,13) mit den jeweiligen Stanzgittern (3,14) eine elektrische und/oder eine mechanische Verbindung ist.

4. Elektronikmodul nach einem der vorhergehenden Ansprüche, **dadurch gekennzeichnet, dass** die Verbindung der Substrate (2,13) mit den jeweiligen Stanzgittern (3,14) eine Klebeverbindung und/oder eine Bondverbindung und/oder eine Lötverbindung ist.

5. Elektronikmodul nach einem der vorhergehenden Ansprüche, **dadurch gekennzeichnet, dass** die Verbindung des ersten Stanzgitters (3) mit dem zweiten Stanzgitter (14) eine die Stanzgitter (3,14) elektrisch kontaktierende Verbindung ist.

6. Elektronikmodul nach einem der vorhergehenden Ansprüche, **dadurch gekennzeichnet, dass** die elektrisch kontaktierende Verbindung eine Schweiß-, Tox- und/oder Klemmverbindung ist.

7. Verfahren zur Herstellung eines Elektronikmoduls mit einem ersten und mindestens einem zweiten Substrat, die jeweils mindestens ein elektronisches Bauelement aufweisen, mit folgenden Schritten:
- Verbinden des ersten Substrats mit einem ersten Stanzgitter zu einer ersten Baueinheit und Verbinden des zweiten Substrats mit einem zweiten Stanzgitter zu einer zweiten Baueinheit,
- Anordnen der Baueinheiten nebeneinander, wobei deren Stanzgitter in mindestens einem Bereich gegeneinander treten,
- Verbinden des ersten und des zweiten Stanzgitters an mindestens einer Stelle des Bereichs und
- gemeinsames Einbetten der Baueinheiten in ein als Spritzgussgehäuse oder Spritzpressgehäuse ausgebildetes Gehäuse.

8. Verfahren nach einem der vorhergehenden Ansprüche, **dadurch gekennzeichnet, dass** die Substrate mit den zugeordneten Stanzgittern durch Kleben und/oder Bonden und/oder Löten verbunden werden.

9. Verfahren nach einem der vorhergehenden Ansprüche, **dadurch gekennzeichnet, dass** die beiden Stanzgitter beim Verbinden elektrisch kontaktiert werden.

10. Verfahren nach einem der vorhergehenden Ansprüche, **dadurch gekennzeichnet, dass** die nebeneinander angeordneten Baueinheiten in einer von Werkzeugsegmenten eines Spritzgießwerkzeugs gebildeten Kavität aufgenommen und durch Spritzgießen eingebettet werden.

11. Verfahren nach einem der vorhergehenden Ansprüche, **dadurch gekennzeichnet, dass** mindestens eines der Stanzgitter zusätzlich zu den Anschlüssen mindestens eine die Kavität mitbildende Zusatzstruktur (7, 16) aufweist, die nach dem Einbetten der Baueinheiten im Spritzgussgehäuse zumindest teilweise entfernt wird.

12. Verfahren nach Anspruch 11, **dadurch gekennzeichnet, dass** die Zusatzstruktur zu ihrem Entfernen vom Rest des Stanzgitters durch Stanzen und/oder Laserschneiden und/oder Scheren abgetrennt wird.

## Claims

1. Electronic module comprising a first substrate having at least one electronic component, and comprising a housing embedding the substrate and embodied as an injection-moulded housing or transfer-moulded housing, and comprising electrical connections which project from the housing, are connected to the first substrate and are embodied as a leadframe, **characterized in that** at least one further, second substrate (13) provided with second electrical connections (15) is embedded in the housing (25), wherein the second connections (15) are embodied as a second leadframe (14) and the two leadframes (3, 14) are directly connected to one another at at least one location (19).

2. Electronic module according to Claim 1, **characterized in that** at least one of the substrates (2, 13) is a ceramic substrate (10, 17), in particular an LTCC substrate (10) or a DBC substrate (17).

3. Electronic module according to either of the preceding claims, **characterized in that** the connection of the substrates (2, 13) to the respective leadframes (3, 14) is an electrical and/or a mechanical connection.

4. Electronic module according to any of the preceding claims, **characterized in that** the connection of the substrates (2, 13) to the respective leadframes (3, 14) is an adhesive connection and/or a bonding connection and/or a soldering connection.

5. Electronic module according to any of the preceding claims, **characterized in that** the connection of the first leadframe (3) to the second leadframe (14) is a connection that makes electrical contact with the leadframes (3, 14).

6. Electronic module according to any of the preceding claims, **characterized in that** the connection that makes electrical contact is a welding, Tox clinching and/or clamping connection.

7. Method for producing an electronic module comprising a first and at least one second substrate each having at least one electronic component, comprising the following steps:
- connecting the first substrate to a first leadframe to form a first structural unit and connecting the second substrate to a second leadframe to form a second structural unit,
- arranging the structural units alongside one another, wherein the leadframes thereof make contact with one another in at least one region,
- connecting the first and second leadframes at at least one location of the region, and
- jointly embedding the structural units into a housing embodied as an injection-moulded housing or transfer-moulded housing.

8. Method according to any of the preceding claims, **characterized in that** the substrates are connected to the assigned leadframes by adhesive bonding and/or bonding and/or soldering.

9. Method according to any of the preceding claims, **characterized in that** electrical contact is made with the two leadframes during connection.

10. Method according to any of the preceding claims, **characterized in that** the structural units arranged alongside one another are accommodated in a cavity formed by mould segments of an injection mould and are embedded by injection moulding.

11. Method according to any of the preceding claims, **characterized in that** at least one of the leadframes has, in addition to the connections, at least one additional structure (7, 16) which concomitantly forms the cavity and which is at least partly removed after the embedding of the structural units in the injection-moulded housing.

12. Method according to Claim 11, **characterized in that** additional structure is separated for the removal thereof from the rest of the leadframe by stamping and/or laser cutting and/or shearing.

## Revendications

1. Module électronique comprenant un premier substrat qui présente au moins un composant électronique et un boîtier réalisé sous la forme d'un boîtier moulé par injection ou moulé par transfert qui enrobe le substrat et comprenant des bornes faisant saillie hors du boîtier, reliées avec le premier substrat et réalisées sous la forme d'une grille estampée, **caractérisé en ce qu'**au moins un deuxième substrat (13) supplémentaire muni de deuxièmes bornes électriques (15) est enrobé dans le boîtier (25), les deuxièmes bornes (15) étant réalisées sous la forme d'une deuxième grille estampée (14) et les deux grilles estampées (3, 14) étant reliées directement l'une à l'autre en au moins un point (19).

2. Module électronique selon la revendication 1, **caractérisé en ce qu'**au moins l'un des substrats (2, 13) est un substrat en céramique (10, 17), notamment un substrat LTCC (10) ou un substrat DBC (17).

3. Module électronique selon l'une des revendications précédentes, **caractérisé en ce que** la liaison des substrats (2, 13) avec les grilles estampées (3, 14) respectives est une liaison électrique et/ou mécanique.

4. Module électronique selon l'une des revendications précédentes, **caractérisé en ce que** la liaison des substrats (2, 13) avec les grilles estampées (3, 14) respectives est une liaison collée et/ou une liaison métallisée et/ou une liaison brasée.

5. Module électronique selon l'une des revendications précédentes, **caractérisé en ce que** la liaison de la première grille estampée (3) avec la deuxième grille estampée (14) est une liaison qui met les grilles estampées (3, 14) en contact électrique.

6. Module électronique selon l'une des revendications précédentes, **caractérisé en ce que** la liaison de mise en contact électrique est une liaison soudée, un assemblage TOX et/ou une liaison par serrage.

7. Procédé de fabrication d'un module électronique comprenant un premier substrat et au moins un deuxième substrat, lesquels présentent respectivement au moins un composant électronique, avec les étapes suivantes :
- Liaison du premier substrat avec une première grille estampée pour former un premier sous-ensemble et liaison du deuxième substrat avec une deuxième grille estampée pour former un deuxième sous-ensemble,
- Disposition des sous-ensembles l'un à côté de l'autre, leurs grilles estampées s'appuyant l'une contre l'autre au moins dans une zone,
- Liaison de la première grille estampée et de la deuxième grille estampée en au moins un point de la zone et
- Enrobage commun des sous-ensembles dans un boîtier réalisé sous la forme d'un boîtier moulé par injection ou moulé par transfert.

8. Procédé selon l'une des revendications précédentes, **caractérisé en ce que** les substrats sont reliés avec les grilles estampées correspondantes par collage et/ou métallisation et/ou brasage.

9. Procédé selon l'une des revendications précédentes, **caractérisé en ce que** les deux grilles estampées sont mises en contact électrique lors de la liaison.

10. Procédé selon l'une des revendications précédentes, **caractérisé en ce que** les sous-ensembles disposés l'un à côté de l'autre sont logés dans une cavité formée par les segments d'outil d'un outil de moulage par injection et sont enrobés par moulage par injection.

11. Procédé selon l'une des revendications précédentes, **caractérisé en ce qu'**au moins l'une des grilles estampées présente, en plus des bornes, au moins une structure supplémentaire (7, 16) formant conjointement la cavité et qui est au moins partiellement retirée après l'enrobage des sous-ensembles dans le boîtier moulé par injection.

12. Procédé selon la revendication 11, **caractérisé en ce que** la structure supplémentaire est séparée du reste de la grille estampée par estampage et/ou découpe au laser et/ou cisaillage.
